# EUROPEAN PATENT APPLICATION

(11) **EP 4 834 592 A1**
(43) Date of publication of application: **04.11.2026**
(21) Application number: 26175651.4
(22) Date of filing: 30.04.2026
(51) Int. Cl.: B41J 2/16

(54) **LIQUID EJECTION HEAD AND METHOD FOR PRODUCING LIQUID EJECTION HEAD**

(30) Priority: 02.05.2025 JP 2025076620
(71) Applicant: Canon Kabushiki Kaisha, Tokyo 146-8501 (JP)
(72) Inventor: KOBATAKE, Erika, Ohta-ku, Tokyo, 146-8501 (JP); TSUTSUI, Satoshi, Ohta-ku, Tokyo, 146-8501 (JP); HAMADE, Yohei, Ohta-ku, Tokyo, 146-8501 (JP); YAMAJI, Haruka, Ohta-ku, Tokyo, 146-8501 (JP)
(74) Representative: TBK

(57) **Abstract**

A liquid ejection head containing: an ejection port for ejecting a liquid; and an energy generation element for generating energy for ejecting the liquid from the ejection port, wherein a silicone-containing film is formed on a surface of the liquid ejection head where the ejection port is provided, and the silicone-containing film contains a cured product of a resin composition containing a both-terminal epoxy silicone resin and a photocationic polymerization initiator.

## Description

### TECHNICAL FIELD

The present disclosure relates to a liquid ejection head and a method for producing a liquid ejection head.

### BACKGROUND

In general, fluorine-based water-repellent materials are known as materials for forming liquid-repellent antifouling films, and particularly compounds having a perfluoroalkyl group or a perfluoropolyether group have excellent liquid repellency and durability and are widely used in various applications. However, since fluorine-containing compounds have high chemical stability and are resistant to decomposition, in the case of being continuously discharged to the environment, the fluorine-containing compounds remain in the environment for a long period of time and may affect human health or the habitat and growth of animals and plants through the environment and food chain. Therefore, recently, in order to achieve a sustainable society such as a circulatory society, there has been a desire for converting fluorine-based water-repellent materials to non-fluorine-based water-repellent materials.

Silicone compounds are fluorine-free water-repellent materials, also exhibit excellent liquid repellency, and can be used as an alternative to fluorine-based water-repellent materials. Silicone compounds are capable of resolving environmental impact, concerns in fluorine sources, and the like.

For example, Japanese Patent Laid-Open No. 2001-158818 discloses a method in which a silicone compound, particularly, a siloxane-containing epoxy resin composition is used as a non-fluorine-based water-repellent material.

### SUMMARY

Liquid repellency such as ink resistance is required for liquid ejection heads such as an inkjet recording head, and water-repellent materials are sometimes applied to the surfaces of members in the vicinities or the like of ejection ports.

Fluorine-based, silicone-based, and other water-repellent materials may exhibit water repellency by segregating a water-repellent group at the surface of a water-repellent antifouling film. The present inventors have recognized that when a water-repellent material having a comb-like water-repellent structure, as in Japanese Patent Laid-Open No. 2001-158818, comes into contact with ink used for commercial and industrial printing, structural deterioration occurs, and the liquid repellency deteriorates.

The present disclosure provides a liquid ejection head having excellent liquid repellency that is capable of dealing with ink used in commercial printing and industrial printing and a method for producing a liquid ejection head.

The present disclosure in its first aspect provides a liquid ejection head as specified in claim 1. Optional features are specified in claim 2 to 14.

The present disclosure in its second aspect provides a method for producing a liquid ejection head as specified in claim 15.

According to the present disclosure, a liquid ejection head having excellent liquid repellency that is capable of dealing with ink used in commercial printing and industrial printing and a method for producing a liquid ejection head are provided. The liquid ejection head according to the present disclosure exhibits favorable water repellency even when not having any fluorine-based water-repellent materials. Therefore, the technique described in the present specification can contribute to achieving a sustainable society such as a decarbonized/circular society.

Features of the present disclosure will become apparent from the following description of embodiments with reference to the attached drawings. The following description of embodiments is described by way of example.

### BRIEF DESCRIPTION OF THE DRAWINGS

FIGS. 1A and 1B are schematic views of an inkjet recording head for which a silicone-containing film is used.
FIGS. 2A to 2H are views for describing an example of a method for producing the inkjet recording head for which a silicone-containing film is used.
FIGS. 3A to 3H are views for describing an example of a method for producing the inkjet recording head for which a silicone-containing film is used.
FIGS. 4A and 4B are views for describing a procedure for forming a silicone-containing film.
FIGS. 5A and 5B are schematic views of an inkjet recording head for which a silicone-containing film is used.
FIGS. 6A to 6D are schematic views showing a method for forming a liquid-repellent antifouling film on an ejection port.

### DESCRIPTION OF THE EMBODIMENTS

In the present disclosure the notations "from XX to YY" and "XX to YY" representing a numerical value range signify, unless otherwise specified, a numerical value range that includes the lower limit and the upper limit of the range, as endpoints. In a case where numerical value ranges are described in stages, the upper limits and the lower limits of the respective numerical value ranges can be combined arbitrarily. In the present disclosure, for instance, a wording such as "at least one selected from the group consisting of XX, YY and ZZ" encompasses XX, YY and ZZ, a combination of XX and YY, a combination of XX and ZZ, a combination of YY and ZZ, and a combination of XX, YY and ZZ.

Hereinafter, an embodiment of the present disclosure will be described, but the present disclosure is not limited only to this embodiment, and not all combinations of features described in the present embodiment are essential to the solution of the present disclosure. Constituent elements described in the embodiment are merely examples and do not intend to limit the scope of the present disclosure only thereto.

As described above, when a water-repellent material having a comb-like water-repellent structure comes into contact with ink used in commercial and industrial printing, the liquid repellency may become insufficient. It is considered that adhesion of a pigment component contained in pigment ink used in commercial and industrial printing or structural deterioration due to a large amount of a solvent occurs, and as a result, the liquid repellency deteriorates. On the other hand, in a liquid ejection head of the present disclosure, it is possible to form a film having excellent liquid repellency with a silicone-containing film for which a both-terminal epoxy silicone resin is used. The silicone-containing film can be used as a water- and oil-repellent film. Hereinafter, the both-terminal epoxy silicone resin in the liquid ejection head will be described.

### Both-Terminal Epoxy Silicone Resin

Silicone has low surface free energy and exhibits liquid repellency. The degree of freedom of the silicone main chain changes depending on the structure of a silicone compound and the length of the silicone main chain, which affects the liquid repellency. In a case where a silicone compound has an epoxy group at one terminal, the degree of freedom of the silicone main chain is high, and the liquid repellency tends to deteriorate in a liquid repellency test. Specifically, it is considered that when silicone has no reactive group at one terminal, the degree of freedom is high, but the bond between a silicone chain and a resin is weak, and when silicone comes into contact with ink used for commercial and industrial printing, structure deterioration occurs due to a pigment or a solvent.

On the other hand, in a case where a silicone compound has epoxy groups at both terminals as in a both-terminal epoxy silicone resin, it is considered that the silicone compound undergoes linear polymerization and the degree of freedom of the silicone main chain becomes low. Therefore, it is considered that the silicone main chain is fixed, and even in a case where ink used in commercial and industrial printing is used, the liquid repellency is less likely to deteriorate in the liquid repellency test.

In the case of a silicone compound having an epoxy-containing group at a side chain, instead of at both terminals, since the silicone main chain has a degree of freedom at the terminals, similar to a one-terminal type, the liquid repellency tends to easily deteriorate in the liquid repellency test.

On the other hand, in a side-chain both-terminal type epoxy silicone resin having epoxy-containing groups in at least some side chains in addition to at both terminals, since the degree of freedom of the silicone main chain becomes low, it is considered that the liquid repellency is less likely to deteriorate in the liquid repellency test. Therefore, the both-terminal epoxy silicone resin is preferably at least one selected from the group consisting of both-terminal linear epoxy silicone resins and side-chain both-terminal epoxy silicone resins and more preferably a both-terminal linear epoxy silicone resin.

The present disclosure relates to a liquid ejection head having an ejection port for ejecting a liquid and an energy generation element for generating energy for ejecting the liquid from the ejection port. In addition, a silicone-containing film is formed on a surface of the liquid ejection head where the ejection port is provided, and the silicone-containing film may contain a cured product of a resin composition containing a both-terminal epoxy silicone resin and a photocationic polymerization initiator. The liquid ejection head of the present disclosure has excellent liquid repellency even against ink used in commercial printing and industrial printing.

The resin composition containing a both-terminal epoxy silicone resin and a photocationic polymerization initiator is, for example, a photosensitive resin composition. The both-terminal epoxy silicone resin is not particularly limited, and a known epoxy silicone resin can be used. The both-terminal epoxy silicone resin is, for example, a silicone oil having epoxy-containing groups at both terminals and preferably an alkyl polysiloxane having epoxy-containing groups at both terminals. The number of carbon atoms in an alkyl group in the alkyl polysiloxane is preferably 1 to 12 and more preferably 1 to 4. The both-terminal epoxy silicone resin may have epoxy-containing groups in at least both terminals and may further have an epoxy-containing group at a position other than both terminals, for example, at a side chain.

The both-terminal epoxy silicone resin is preferably an alkylsiloxane resin having a structure indicated by the following formula (1) and more preferably an alkylsiloxane resin having a structure indicated by the following formula (1-2).

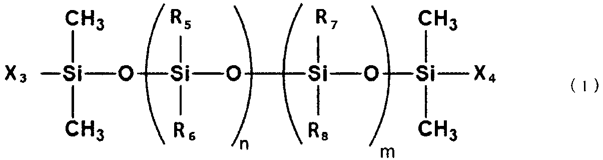

In formula (1), R₅ and R₆ are each independently an alkyl group having 1 to 12 carbon atoms or an aryl group having 6 to 12 carbon atoms,
X₃ and X₄ are each independently an epoxy-containing group,
R₈ is an epoxy-containing group, an alkyl group having 1 to 12 carbon atoms, or an aryl group having 6 to 12 carbon atoms,
R₇ is an alkyl group having 1 to 12 carbon atoms or an aryl group having 6 to 12 carbon atoms, and
arrangements of the structure in a parenthesis with m and the structure in a parenthesis with n may be random arrangements or block arrangements, m is an integer of 0 to 3, and n + m is an integer of 1 to 60.

Preferably, R₅ and R₆ are each independently an alkyl group having 1 to 4 carbon atoms,
R₈ is an epoxy-containing group or an alkyl group having 1 to 4 carbon atoms,
R₇ is an alkyl group having 1 to 4 carbon atoms, and
m is 0 or 1.

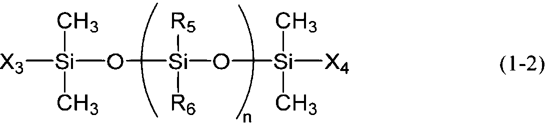

In a formula (1-2), R₅ and R₆ are each independently an alkyl group having 1 to 12 carbon atoms or an aryl group having 6 to 12 carbon atoms.

X₃ and X₄ are each independently an epoxy-containing group, and n is an integer of 1 to 60.

Examples of the epoxy-containing group include groups having a glycidyl ether group or groups having an alicyclic epoxy group. The epoxy-containing group is preferably a group having a glycidyl ether group or a group having an epoxycyclohexyl group.

The epoxy-containing group is more preferably a glycidoxyalkyl group having 1 to 4 (preferably 2 to 4) carbon atoms in an alkyl chain or an epoxycyclohexylalkyl group having 1 to 8 (preferably 2 to 6) carbon atoms in an alkyl chain. The epoxy-containing group is still more preferably a 3-glycidoxyalkyl group having 1 to 4 (preferably 2 to 4) carbon atoms in an alkyl chain or a 2-(3,4-epoxycyclohexyl)alkyl group having 1 to 8 (preferably 2 to 6) carbon atoms in an alkyl chain.

Still more preferable examples of the epoxy-containing group include a 3-glycidoxypropyl group, a 2-(3,4-epoxycyclohexyl)ethyl group, and a 2-(3,4-epoxycyclohexyl)pentyl group. The epoxy-containing group is far still more preferably a 2-(3,4-epoxycyclohexyl)ethyl group. In particular, the epoxycyclohexylalkyl group has excellent reactivity, and high liquid repellency can be obtained.

As the alkyl group having 1 to 12 carbon atoms in formula (1) and formula (1-2), particularly, alkyl groups having 1 to 4 carbon atoms such as a methyl group, an ethyl group, a propyl group, or a butyl group are preferable, and a methyl group is more preferable. From the viewpoint of compatibility with a resin or the film strength, a phenyl group or the like may be present as the aryl group having 6 to 12 carbon atoms in formula (1)

In formula (1), m + n is 1 to 60 and preferably 10 to 60 from the viewpoint of compatibility with a resin and solubility in a solvent. From the viewpoint of liquid repellency, m + n is more preferably 30 to 60. m + n may be 20 to 60 and may also be 25 to 45.

m in formula (1) is preferably 0 or 1. In addition, arrangements of the structure in a parenthesis with m and the structure in a parenthesis with n may be a random arrangement or a block arrangement. The arrangements of the structure in the parenthesis with m and the structure in the parenthesis with n are preferably random arrangements.

In formula (1-2), n is 1 to 60 and preferably 10 to 60 from the viewpoint of compatibility with a resin and solubility in a solvent. From the viewpoint of liquid repellency, n is more preferably 30 to 60. n may be 20 to 60 or may be 25 to 45.

In the present disclosure, the above-described both-terminal epoxy silicone resin is used, whereby the bond of the silicone compound becomes stronger, and higher liquid repellency is exhibited.

The thickness of the silicone-containing film is not particularly limited. The thickness of the silicone-containing film is, for example, 0.1 to 100 µm, preferably 0.1 to 10 µm, and more preferably 0.2 to 2.0 µm.

In addition, a silane coupling agent may be added to the silicone compound for the purpose of enhancing the adhesiveness to an underlying film such as an inorganic film. The silicone-containing film may be, for example, a laminate having a silicone-containing film (a layer containing silicone) on a base material.

### Epoxy Resin

In addition, it is also effective to use an epoxy resin in a resin composition used for the formation of the silicone-containing film. For example, in the polymerization of the both-terminal epoxy silicone resin, a linear structure is mainly formed, but it is considered that when the both-terminal epoxy silicone resin and the epoxy resin are jointly used, silicone is disposed in the network structure of the epoxy resin, and liquid repellency further improves. An alicyclic epoxy resin is preferably used as the epoxy resin from the viewpoint of forming a strong bond.

The resin composition preferably contains an epoxy resin different from the both-terminal epoxy silicone resin. The silicone-containing film may be a cured product of a resin composition containing the both-terminal epoxy silicone resin, the photocationic polymerization initiator, and the epoxy resin. The silicone-containing film contains, for example, an epoxy resin as a binder.

The epoxy resin is preferably a cationic polymerization type epoxy resin, and can be selected in consideration of the adhesion performance, mechanical strength, and swelling resistance of the cured product of the resin composition. The epoxy resin is, for example, a resin different from the alkylsiloxane resin having the structure indicated by formulae (1) and (1-2) shown above.

The epoxy resin is preferably at least one selected from the group consisting of an epoxy resin having an alicyclic skeleton, an epoxy resin having a bisphenol skeleton, an epoxy resin having a phenol novolac skeleton, an epoxy resin having a cresol novolac skeleton, an epoxy resin having a norbornene skeleton, an epoxy resin having a terpene skeleton, an epoxy resin having a dicyclopentadiene skeleton, and an epoxy resin having an oxycyclohexane skeleton.

More specific examples thereof may include cationic polymerization type epoxy resins, such as polyfunctional epoxy resins, such as epoxy resins having an alicyclic skeleton such as a cyclohexane skeleton, epoxy resins having a bisphenol skeleton such as bisphenol A-type and F-type epoxy resins, epoxy resins having a phenol novolac skeleton such as a phenol novolac-type epoxy resin, epoxy resins having a cresol novolac skeleton such as a cresol novolac-type epoxy resin, epoxy resins having a norbornene skeleton, epoxy resins having a terpene skeleton, epoxy resins having a dicyclopentadiene skeleton, and epoxy resins having an oxycyclohexane skeleton. These can be used singly or two or more thereof can be used in combination.

The epoxy resin more preferably has an alicyclic epoxy resin. The alicyclic epoxy resin has favorable reactivity with cationic catalysts and is capable of making the crosslinking density of a cured product higher than other epoxy resins. In addition, the epoxy resin preferably has no benzene ring.

In addition, the epoxy equivalent of the epoxy resin is preferably 300 g/eq. or less. The epoxy equivalent is preferably 100 to 300 g/eq., more preferably 100 to 230 g/eq., still more preferably 100 to 200 g/eq., and far still more preferably 150 to 200 g/eq. When the epoxy equivalent is 300 g/eq. or less, the epoxy resin has excellent reactivity with silicone compounds and is thus superior in terms of ink durability.

The epoxy equivalent is defined by (molecular weight of epoxy resin/number of epoxy groups in one molecule of epoxy resin).

When an epoxy resin having two or more epoxy groups is used as the epoxy resin, the cured product three-dimensionally cross-links, and desired curability can be obtained. It is more suitable to use an epoxy resin having three or more epoxy groups. Furthermore, a tri-or higher functional epoxy resin may be used after at least one bifunctional epoxy resin is added thereto.

Examples of commercially available tri- or higher functional epoxy resins include "jER157S70" and "jER1031S" (trade names) manufactured by Mitsubishi Chemical Corporation, "EPICLON N-695" and "EPICLON N-865" (trade names) manufactured by DIC Corporation, "CELLOXIDE 2021", "GT-300 series", "GT-400 series", and "EHPE3150" (trade names) manufactured by Daicel Corporation, "SU8" (trade name) manufactured by Nippon Kayaku Co., Ltd., "VG3101" (trade name) and "EPOX-MKR1710" (trade name) manufactured by Printec Corporation, "DENACOL series" manufactured by Nagase ChemteX Corporation, and the like.

Examples of commercially available bifunctional epoxy resins include "jER1004", "jER1007", "jER1009", "jER1010", and "jER1256" (trade names) manufactured by Mitsubishi Chemical Corporation, and "EPICLON 4050" and "EPICLON 7050" (trade names) manufactured by DIC Corporation, and the like.

The content of the both-terminal epoxy silicone compound in the resin composition containing the epoxy resin capable of forming the silicone-containing film, a photocationic polymerization initiator, and the both-terminal epoxy silicone resin (preferably an alkylsiloxane resin having the structure indicated by formula (1)) is, for example, 0.1 to 10.0 parts by mass, preferably 0.2 to 5.0 parts by mass, more preferably 0.4 to 2.0 parts by mass, and still more preferably 0.5 to 1.5 parts by mass relative to 100 parts by mass of the epoxy resin different from the both-terminal epoxy silicone resin.

When the content is within the above-described range, higher liquid repellency can be obtained.

### Coating Solvent

In a case where the resin composition is applied as a solution, a polar organic solvent is preferably used as a coating solvent from the viewpoint of solubility. Specific examples thereof include polar solvents such as alcohols, ketones, esters such as ethyl acetate, butyl acetate, and propylene glycol monomethyl ether acetate (PGMEA), ethers such as diglyme, tetrahydrofuran, and PGME, and glycols such as diethylene glycol. Examples of the alcohols include methanol, ethanol, propanol, isopropanol, butanol, and the like and examples of the ketones include methyl ethyl ketone and methyl isobutyl ketone.

The resin composition preferably contains an organic solvent. The amount of the organic solvent may be changed depending on a method for applying the resin composition such as ease of application. The content of the organic solvent in the resin composition is, for example, 100 to 1500 parts by mass and 600 to 1200 parts by mass relative to 100 parts by mass of the resin contained in the resin composition.

### Photocationic Polymerization Initiator

The resin composition contains a photocationic polymerization initiator. Therefore, the resin composition may be a photosensitive resin composition. When the resin composition is applied and cured on a base material, the resin composition is made into a cured product by light irradiation with the photocationic polymerization initiator, whereby silicone-containing film, which is a liquid-repellent antifouling film, can be formed. In this case, liquid repellency or mechanical strength significantly improves as compared with that in the case of heat curing, and furthermore fine processing by patterning also becomes possible.

As the photopolymerization initiator, a photocationic polymerization initiator that can be cured at a low temperature and has a high catalytic function can be suitably used. As a specific photocationic polymerization initiator, an ionic acid generator can be selected. For a cationic moiety, an onium system with high absorption can be selected, and onium ions such as oxonium, ammonium, phosphonium, and sulfonium, iodonium can be selected, and among these, sulfonium having high i-line (wavelength 365 nm) absorption and excellent cationic polymerization performance and cross-linking reaction performance is more preferable.

Specific examples of sulfonium-based cation ions include triaryl sulfonium such as triphenylsulfonium, tri-p-tolylsulfonium, tri-o-tolylsulfonium, tris(4-methoxyphenyl)sulfonium, 1-naphthyldiphenylsulfonium, 2-naphthyldiphenylsulfonium, tris(4-fluorophenyl)sulfonium, tri(1-naphthyl)sulfonium, tri(2-naphthyl)sulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis[4-(diphenylsulfonio)phenyl]sulfide, bis[4-{bis(4-(2-hydroxyethoxy)phenyl]sulfonio}phenyl]sulfide, bis{4-[bis(4-fluorophenyl)sulfonio]phenyl}sulfide, bis{4-[bis(4-methylphenyl)sulfonio]phenyl}sulfide, bis{4-[bis(4-methoxyphenyl)sulfonio]phenyl}sulfide, 4-(4-benzoyl-2-chlorophenylthio)phenylbis(4-fluorophenyl)sulfonium, 4-(4-benzoyl-2-chlorophenylthio)phenyldiphenylsulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-yl phenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thiaanthrenium, 5-phenylthiaanthrenium, 5-tolylthiaanthrenium, 5-(4-ethoxyphenyl)thiaanthrenium, and 5-(2,4,6-trimethylphenyl)thiaanthrenium; diaryl sulfoniums such as diphenylphenacylsulfonium, diphenyl-4-nitrophenacylsulfonium, diphenylbenzylsulfonium, and diphenylmethylsulfonium; monoaryl sulfoniums such as phenylmethylbenzylsulfonium, 4-hydroxyphenylmethylbenzylsulfonium, 4-methoxyphenylmethylbenzylsulfonium, 4-(acetylcarbonyloxy)phenylmethylbenzylsulfonium, 4-hydroxyphenylmethyl-1-naphthylmethylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-(acetylcarbonyloxy)phenylmethylphenacylsulfonium, 2-naphthylmethylphenacylsulfonium, 2-naphthyloctadecylphenacylsulfonium, and 9-anthrylmethylphenacylsulfonium; and trialkyl sulfonium such as dimethylphenacyl sulfonium, phenacyl tetrahydrothiophenium, dimethylbenzyl sulfonium, benzyltetrahydrothiophenium, and octadecylmethylphenacyl sulfonium.

A molar extinction coefficient of the photopolymerization initiator at a wavelength of 365 nm is preferably 400 M⁻¹ cm⁻¹ or more. When the molar extinction coefficient is 400 M⁻¹ cm⁻¹ or more, the crosslinking density does not decrease during a curing reaction, and it is possible to develop water-repellency and impart photo-patterning properties.

A method for measuring the molar extinction coefficient of a compound such as a photopolymerization initiator is as follows. The compound of interest is dissolved in a solvent that does not have absorption at 365 nm, such as acetonitrile, to form a solution and charged into a quartz cell, and the absorbance at 365 nm is measured using an ultraviolet visible near-infrared spectrophotometer (manufactured by JASCO Corporation). The molar extinction coefficient can be calculated from the obtained absorbance with the following formula.

Molar extinction coefficient = absorbance/molar concentration of compound/optical path of cell

For an anion moiety, a borate-based anion, a phosphorus-based anion, an antimony-based anion, and a gallate-based anion having high acid strength can be selected, and at least one selected from the group consisting of a gallate-based anion and a borate-based anion is preferable. Among these, tetrakis(pentafluorophenyl) borate ions, trifluortris(pentafluoroethyl) phosphate ions, hexafluoroantimonate ions, and tetrakis(pentafluorophenyl) gallate ions are more preferable, which are excellent in cationic polymerization performance and crosslinking reaction performance. This makes it possible to develop water-repellency and impart photo-patterning properties for the same reasons as the cation selection reasons.

Examples of the above-described photocationic polymerization initiator that can be suitably used include "ADEKA ARKLS SP-170", "ADEKAARKLS SP-172", and "ADEKA ARKLS SP-150" (all trade names) manufactured by ADEKA Corporation, "BBI-103" and "BBI-102" (both trade names) manufactured by Midori Kagaku Co., Ltd, and the like. Additionally, the examples include "IBPF", "IBCF", "TS-01", and "TS-91" (all trade names) manufactured by SANWA CHEMICAL CO., LTD., and "CPI-410S", "CR-C1", "CPI-410B", "CPI-310B", "CPI-310FG", "ES-1B", "VC-1FG", and "CPI-101A" (all trade names) manufactured by San-Apro Ltd., and the like. Furthermore, the composition may contain a basic substance such as amines, a photosensitizer such as an anthracene derivative, a silane coupling agent, and the like for the purpose of improving the photo-lithography performance, adhesion performance, and the like.

The content of the photopolymerization initiator can be changed as appropriate depending on the resin used and is not particularly limited. The addition amount of the photopolymerization initiator is, for example, 0.09 to 7.0 parts by mass, preferably 1.4 to 6.0 parts by mass, more preferably 1.9 to 5.5 parts by mass, and still more preferably 2.5 to 5.2 parts by mass relative to 100 parts by mass of the resin (preferably the epoxy resin) contained in the photosensitive resin composition.

### Base Material

The silicone-containing film can be used as a liquid-repellent antifouling film in the liquid ejection head. A base material forming the silicone-containing film is, for example, a surface where an ejection port is provided. The silicone-containing film may be further provided at a position other than the surface of the liquid ejection head where the ejection port is provided. Materials of the surface where the ejection ports is provided, which serves as the base material, and the other members of the liquid ejection head are not particularly limited, and can be selected mainly from inorganic substrates and resin compositions.

Examples of the inorganic substrates include Si, SiO₂, SiOC, SiC, SiCN, Ta, TaO, Al₂O₃ and the like.

As the resin composition, a negative type epoxy resin composition containing a polyfunctional epoxy resin as a main agent is used. Specific examples thereof include a bisphenol A-type epoxy resin, a bisphenol E-type epoxy resin, a bisphenol F-type epoxy resin, a novolac-type epoxy resin, a cresol novolac-type epoxy resin, an alicyclic epoxy resin, and the like.

The surface where the ejection port is provided preferably is a cured product of the negative type epoxy resin composition containing a polyfunctional epoxy resin. When the surface where the ejection port is provided is the above-described material, the adhesiveness to the silicone-containing film becomes more favorable, and the liquid repellency can be more favorably exhibited. As the epoxy resin that can be used for the surface where the ejection port is provided, epoxy resins described above as the epoxy resin in the resin composition can also be used.

Examples of commercially available epoxy resins include "157S70" and "jER1031S" (both trade names) manufactured by Mitsubishi Chemical Corporation, "EPICLON N-695" and "EPICLON N-865" (both trade names) manufactured by DIC Corporation, and the like. Additionally, the examples include "CELLOXIDE 2021", "GT-300 series", "GT-400 series", and "EHPE3150" (all trade names) manufactured by Daicel Corporation, "SU8" (trade name) manufactured by Nippon Kayaku Co., Ltd., "VG3101" and "EPOX-MKR1710" (both trade names) manufactured by Printec Corporation, "DENACOL series" (trade name) manufactured by Nagase ChemteX Corporation, and the like.

The epoxy ring-opening rate of the cured product of the resin composition is preferably 40% or more. The epoxy ring-opening rate is preferably 40% to 100%, more preferably 55% to 99%, still more preferably 60% to 99%, and far still more preferably 65% to 99%. When the epoxy ring-opening rate is within the above-described range, it is considered that the silicone compound is more sufficiently fixed and the liquid repellency becomes more favorable.

The epoxy ring-opening rate can be controlled by the kind of the epoxy resin used and the kind and amount of the photocationic polymerization initiator.

As an example of the application of the silicone-containing film, a method for producing a liquid ejection head such as an inkjet recording head in which a silicone-containing film is used as a liquid-repellent antifouling film will be described below with reference to drawings. The application scope of the silicone-containing film according to the present disclosure is not limited thereto.

### Method for Producing Liquid Ejection Head

### Recording Head 1 in Which Resin Composition Is Used as Base Material

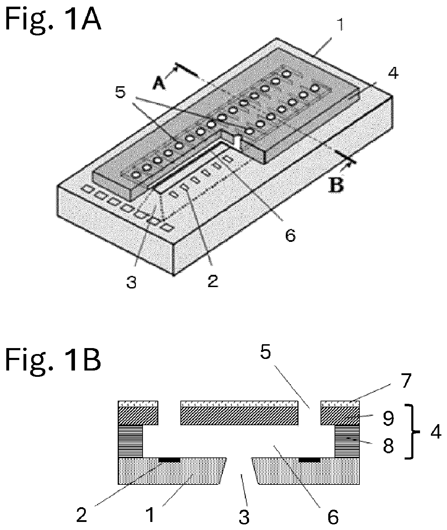

FIG. 1A is a schematic view showing an example of a liquid ejection head such as an inkjet recording head. FIG. 1B is a cross-sectional view of this recording head viewed in a cross-section perpendicular to a substrate 1 passing A and B in FIG. 1A.

The recording head shown in FIGS. 1A and 1B has a substrate 1 on which two rows of energy generation elements 2 for generating energy used to eject liquid are formed side by side at a predetermined pitch. In the substrate 1, a liquid feeding port 3 is opened between the two rows of energy generation elements 2. On the substrate 1, ejection ports 5 provided at positions facing the energy generation elements 2, respectively, are formed with an ejection port-forming member 4.

The shape of the ejection port 5 may be a so-called tapered shape in which the area of a cross section parallel to the substrate 1 decreases toward the ejection port 5 from the substrate 1 side. The ejection port-forming member 4 is composed of side walls 8 forming an individual flow path 6 communicating with each ejection port 5 from the feeding port 3 and a top plate 9 where the ejection ports 5 are opened. In the ejection port-forming member 4, the side walls 8 and the top plate 9 may be integrated with each other.

A liquid-repellent antifouling film (liquid-repellent layer) 7 is provided on the ejection port-forming member. For example, the inkjet recording head has a silicone-containing film (liquid-repellent antifouling film 7) on a surface where the ejection ports are provided. The liquid-repellent antifouling film 7 prevents ink ejected from the ejection ports 5 from adhering to the surface of the recording head. The shape, material, and the like of the substrate 1 are not particularly limited as long as the substrate 1 is capable of functioning as a part of members constituting the flow paths 6 and functioning as a support for the ejection port-forming member 4. In the present embodiment, a silicon substrate is used as the substrate 1 because processing is easy.

The liquid-repellent antifouling film 7 contains the same resin as the ejection port-forming member, whereby the coatability becomes more favorable, and the flatness of the film can be improved. As a result, it can be considered that the liquid repellency further improves. Therefore, it is preferable that the resin composition contains an epoxy resin different from the both-terminal epoxy silicone resin, and the surface where the ejection ports are provided (for example, the ejection port-forming member) contains a cured product of the epoxy resin. In addition, the epoxy resin that forms the surface where the ejection ports are provided (for example, the ejection port-forming member) preferably contains an epoxy resin having the same structure as the epoxy resin in the resin composition.

The epoxy resin in the resin composition and the epoxy resin forming the surface where the ejection ports are provided (for example, the ejection port-forming member) are preferably at least one selected from the group consisting of an epoxy resin having an alicyclic skeleton, an epoxy resin having a bisphenol skeleton, an epoxy resin having a phenol novolac skeleton, an epoxy resin having a cresol novolac skeleton, an epoxy resin having a norbornene skeleton, an epoxy resin having a terpene skeleton, an epoxy resin having a dicyclopentadiene skeleton, and an epoxy resin having an oxycyclohexane skeleton.

The epoxy resin in the resin composition and the epoxy resin forming the surface where the ejection ports are provided (for example, the ejection port-forming member) more preferably include an alicyclic epoxy resin. It is preferable that the resin composition is a negative type epoxy resin composition containing a polyfunctional epoxy resin and the surface where the ejection ports are provided is a cured product of the negative type epoxy resin composition containing a polyfunctional epoxy resin.

In this recording head, the surface where the ejection ports 5 are provided is disposed to face a recording surface of a recording medium. In addition, energy generated by the energy generation elements 2 is applied to ink loaded into the flow paths 6 via the feeding port 3, ink droplets are ejected from the ejection ports 5, and the ink droplets are made to adhere to a recording medium to perform recording. As the energy generation element 2, an electrothermal conversion element (so-called heater) or the like can be used as an element that generates energy by heat, and a piezoelectric element or the like can be used as an element that generates energy mechanically.

The liquid-repellent antifouling film 7 is a cured product of the resin composition. Specifically, as the liquid-repellent antifouling film 7, a liquid-repellent antifouling film can be formed as a cured product by applying a solution containing the resin composition and curing a coating film of the solution.

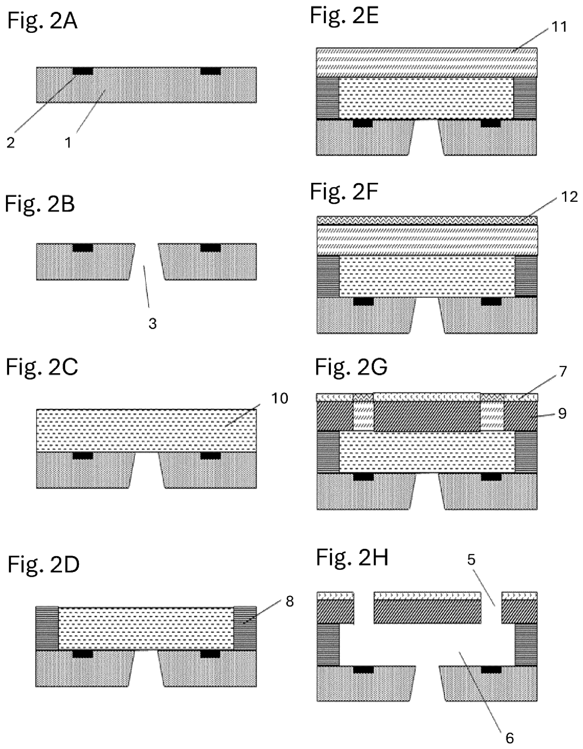

Next, an example of a method for producing an inkjet recording head will be described with reference to FIGS. 2A to 2H. In the inkjet recording head, known components in the art can be used as components other than the liquid-repellent antifouling film 7.

The present disclosure relates to a method for producing a liquid ejection head having an ejection port for ejecting a liquid and an energy generation element for generating energy for ejecting the liquid from the ejection port, wherein a silicone-containing film is formed on a surface of the liquid ejection head where the ejection port is provided, the surface where the ejection port is provided is a surface of an ejection port-forming member that forms a flow path of the liquid that communicates with the ejection port, the production method comprises: a step of forming a photosensitive resin layer that forms the ejection port-forming member; a step of forming a layer of a resin composition that forms the silicone-containing film on the photosensitive resin layer; and a step of exposing and developing the photosensitive resin layer and the layer of the resin composition to form the ejection port-forming member and the silicone-containing film, and the resin composition contains a both-terminal epoxy silicone resin and a photocationic polymerization initiator.

As for the resin composition, it is as described above.

FIGS. 2A to 2H are schematic cross-sectional views showing an example of the method for producing an inkjet recording head according to steps, and the position of the cross section is the same as in FIG. 1B.

First, as shown in FIG. 2A, the substrate 1 having the energy generation elements 2 provided on a surface is prepared. To the energy generation elements 2, a control signal input electrode (not shown) for operating the elements is connected. In addition, various functional layers, such as a protective layer (not shown) for the purpose of improving the durability of the energy generation element 2 and an adhesion improvement layer (not shown) for the purpose of improving the adhesiveness between the ejection port-forming member 4 and the substrate 1, may be provided.

Next, as shown in FIG. 2B, the ink feeding port 3 that penetrates the substrate 1 is formed. The feeding port 3 can be formed using wet etching with an alkaline-based etchant such as tetramethylammonium hydroxide (TMAH) or dry etching such as reactive ion etching.

Next, as shown in FIG. 2C, a first photosensitive resin layer 10 containing a photosensitive resin and a photopolymerization initiator is formed on the substrate 1 including the energy generation elements 2. The first photosensitive resin layer 10 is a so-called negative type photosensitive resin layer. The first photosensitive resin layer 10 is preferably formed by applying a photosensitive resin to a film base material made of PET or polyimide and transferring the photosensitive resin onto the substrate 1 using a laminate method. Since the photosensitive resin contained in the first photosensitive resin layer 10 satisfies various performances such as high mechanical strength, adhesiveness to an underlying layer, ink resistance, and resolution for patterning a fine pattern of the ejection ports 5, an epoxy resin can be suitably used.

As the epoxy resin and the photopolymerization initiator, the same epoxy resin and photopolymerization initiator as described above can be used.

The addition amount of the photopolymerization initiator can be set to any addition amount to obtain an intended sensitivity. The addition amount of the photopolymerization initiator is preferably in a range of from 0.5 to 5 mass% relative to the epoxy resin. In addition, a wavelength sensitizing agent may be added as needed, and examples of the wavelength sensitizing agent include "SP-100" (trade name) manufactured by ADEKA Corporation, and "UVS-1101", "UVS-1331", and "UVS-2171" (all trade names) manufactured by AIR WATER PERFORMANCE CHEMICAL INC.

Furthermore, additives may be added to the photosensitive resin as needed. For example, a flexibility-imparting agent may be added for the purpose of reducing the elastic modulus of the epoxy resin or a silane coupling agent may be added to obtain further adhesion to the underlying layer.

Next, as shown in FIG. 2D, pattern exposure is performed via a mask (not shown), and a heat treatment is further performed to form the side walls 8. The mask is formed by forming a light shielding film such as a chromium film on a substrate made of a material such as glass or quartz that transmits light having an exposure wavelength in accordance with the pattern of the flow paths 6. As an exposure device, a single-wavelength light source such as an i-line stepper or a KrF stepper or a projection exposure device having a broad wavelength of a mercury lamp as a light source such as "MASK ALIGNER MPA-600Super" (trade name) manufactured by Canon Inc. can be used.

A second photosensitive resin layer 11 is formed on the substrate 1 in which the side walls 8 have been formed as described above as shown in FIG. 2E (a step of forming a photosensitive resin layer forming the ejection port-forming member). The second photosensitive resin layer 11 is the same negative type photosensitive resin layer as the first photosensitive resin layer 10. As a photosensitive resin contained in the second photosensitive resin layer 11, a bisphenol type epoxy resin or a novolac type epoxy resin is preferably used. The second photosensitive resin layer 11 can be formed by the same method as for the first photosensitive resin layer 10.

The second photosensitive resin layer 11 is capable of forming the surface where the ejection ports are provided. That is, the surface where the ejection ports are provided is the surface (outer surface) of the ejection port-forming member that forms the liquid flow paths communicating with the ejection ports, and the surface (outer surface) of the top plate 9. Therefore, the second photosensitive resin layer 11 is preferably a negative type epoxy resin composition containing a polyfunctional epoxy resin.

Next, as shown in FIG. 2F, a coating film 12 of a solution of the photosensitive resin composition for forming the liquid-repellent antifouling film 7 is formed on the second photosensitive resin layer 11 (a step of forming a layer of the resin composition forming the silicon-containing film on the photosensitive resin layer). The coating film 12 can be formed by applying the resin composition by a method such as a spin coating method, a roll coating method, a slit coating method.

Next, a step of exposing and developing the photosensitive resin layer and the layer of the resin composition to form the ejection port-forming member and the silicone-containing film is performed.

As shown in FIG. 2G, pattern exposure is performed via a mask (not shown) and curing is performed to form the top plate 9 and the liquid-repellent antifouling film 7. The mask is formed by forming a light shielding film such as a chromium film on a substrate made of a material such as glass or quartz that transmits light having an exposure wavelength in accordance with the pattern of the ejection ports 5. As an exposure device, a single-wavelength light source such as an i-line stepper or a KrF stepper or a projection exposure device having a broad wavelength of a mercury lamp as a light source such as "MASK ALIGNER MPA-600Super" (trade name) manufactured by Canon Inc. can be used.

Next, as shown in FIG. 2H, a non-exposed portion of the second photosensitive resin layer 11 and the coating film 12 are removed by a development treatment to form the ejection ports 5. When the second photosensitive resin layer 11 and the coating film 12 are collectively exposed and developed, cationic polymerizable groups in the second photosensitive resin layer 11 and the coating film 12 react with each other, and the liquid-repellent antifouling film 7 having high durability and high antistatic properties can be obtained. At this time, the non-exposed portion of the first photosensitive resin layer 10 is also dissolved and removed at the same time, and flow paths 6 are formed.

Furthermore, a heating treatment is performed as needed, and bonding of a member (not shown) for ink supply and electrical bonding (not shown) for driving the energy generation elements 2 are performed, thereby completing the inkjet recording head.

### Recording Head 2 in Which Resin Composition Is Used as Base Material

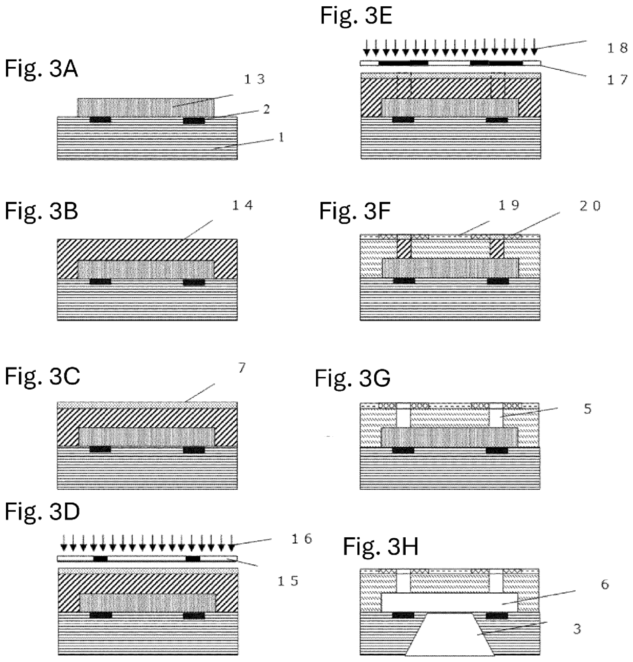

The inkjet recording head may be prepared by steps shown in FIGS. 3A to 3H. The inkjet recording head is an example in which the side walls 8 and the top plate 9 in the ejection port-forming member 4 are integrated with each other. Therefore, the surface where the ejection ports are provided serves as the surface (outer surface) of the ejection port-forming member.

A method for preparing an inkjet recording head by the steps shown in FIGS. 3A to 3H will be described. First, a positive type photosensitive resin serving as a mold of the ink flow paths 6 is applied onto the substrate 1 provided with the energy generation elements 2 to form a positive type photosensitive resin layer. For example, polymethyl isopropenyl ketone (trade name "ODUR-1010", manufactured by Tokyo Ohka Kogyo Co., Ltd.) is applied by a spin coating method, and a heat treatment is performed thereon at 120°C for six minutes, thereby forming a positive type photosensitive resin layer having a thickness of 14 µm.

Next, the pattern of the ink flow paths is exposed to form a mold material 13 (FIG. 3A). For example, the pattern of the ink flow paths is exposed with an exposure device UX3000 (trade name, manufactured by Ushio Inc.), the exposed portions of the positive type photosensitive resin layer were developed using MIBK (methyl isobutyl ketone), and the exposed portions were then rinsed with IPA (isopropyl alcohol), thereby forming the mold material 13 (FIG. 3A). As described above, the method for producing a liquid ejection head may have a step of forming a mold of the liquid flow paths on the substrate.

Next, a step of forming a photosensitive resin layer that forms the ejection port-forming member is performed. A photocationic polymerizable resin layer 14 for forming the ejection port-forming member that forms the ejection ports 5 is formed (FIG. 3B). A photocationic polymerizable resin contained in the photocationic polymerizable resin layer preferably contains an epoxy resin. The same epoxy resin and photopolymerization initiator as described above can be used. The photocationic polymerizable resin layer 14 is, for example, a negative type.

For example, as the ejection port-forming member for forming the ejection ports 5 that is composed of the photocationic polymerizable resin layer 14, a photocationic polymerizable resin having a composition shown in Table 1 is applied by a spin coating method, and a heat treatment is performed thereon at 60°C for nine minutes, thereby forming the mold material 13 and the photocationic polymerizable resin layer 14 in which the thickness on the mold material 13 reaches 25 µm on the substrate 1 (FIG. 3B).

As described above, the method for producing a liquid ejection head may have a step of applying a photosensitive resin composition that forms the ejection port-forming member onto the substrate on which the mold has been formed to form a cationic polymerizable resin layer.

**Table 1**

| | | |
|---|---|---|
| Epoxy resin | EHPE-3150, Daicel Corporation | 100 Parts by mass |
| Additive | 1,4-HFAB, Central Glass Co., Ltd. | 20 Parts by mass |
| Photocationic polymerization initiator | SP-172, ADEKA | 6 Parts by mass |
| Silane coupling agent | A-187, GE Toshiba Silicones Co., Ltd. | 5 Parts by mass |
| Solvent | Xylene, Kishida Chemical Co., Ltd. | 70 Parts by mass |

Next, a step of forming a layer of a resin composition that forms the silicone-containing film on the photosensitive resin layer is performed. A silicone-containing film (liquid-repellent layer 7) is formed on the photocationic polymerizable resin layer 14 (FIG. 3C). For example, the liquid-repellent layer 7 is applied onto the uncured photocationic polymerizable resin layer 14 by a slit coating method, and a heat treatment is performed thereon at 70°C for three minutes, thereby volatilizing a diluting solvent and forming the liquid-repellent layer 7 in which the thickness on the photocationic polymerizable resin layer 14 reaches 0.5 µm (FIG. 3C). When the same resin as for the photosensitive resin layer is used for the silicone-containing film, the coatability further improves, and the flatness of the film can be improved.

Next, a step of exposing and developing the photosensitive resin layer and the layer of the resin composition to form the ejection port-forming member and the silicone-containing film is performed. The photocationic polymerizable resin layer 14 and the liquid-repellent layer 7 are exposed and developed to form the ejection port-forming member and the liquid-repellent layer 7 (FIGS. 3D to 3G).

For example, first, a first exposure step is performed. Exposure 16 is performed through a first mask 15 at 4000 J/m² using an i-line stepper (manufactured by Canon Inc.) so that portions where the ejection ports 5 are to be formed become unexposed portions (FIG. 3D).

Next, a second exposure step may be performed. A non-liquid-repellent region 19 may be formed as needed by the second exposure step. For example, a region corresponding to the non-liquid-repellent region 19, excluding regions corresponding to the ejection ports 5, is exposed through a second mask 17 at 150 J/m² using MA200compact (trade name, manufactured by SUSS MicroTec K.K.) and wavelengths of 270 nm or shorter (FIG. 3E).

Next, a heat treatment is performed at 95°C for four minutes (FIG. 3F). After that, the non-liquid-repellent region is developed with a mixed solution of xylene/MIBK (methyl isobutyl ketone) (mass ratio of 6/4), and rinsed with xylene, thereby forming the ejection ports 5 (FIG. 3G).

Furthermore, the ink feeding port 3 may be formed (FIG. 3H). For example, anisotropic etching is performed on the substrate 1 using TMAH (tetramethylammonium hydroxide), which is an alkaline solution, to form the feeding port 3. After that, the substrate 1 is immersed into methyl lactate, thereby dissolving and removing the mold material 13 and forming the flow paths 6 (FIG. 3H).

After that, electrical bonding for driving the energy generation elements 2 is performed. Furthermore, an ink feeding member or the like for feeding ink is connected, and an inkjet recording head is prepared. This inkjet recording head was evaluated by evaluation methods which will be described below.

### Recording Method

In a recording method according to the embodiment of the present disclosure, an image is recorded on a recording medium by ejecting liquid, particularly, ink containing a pigment, from the inkjet recording head using the inkjet recording head.

In the inkjet recording head, when the ink is loaded, a side surface of the liquid-repellent antifouling film is in contact with the ink at all times. When the inkjet recording head is used, since the liquid-repellent antifouling film 7 has liquid repellency, it is possible to prevent failed ejection even in the case of using the inkjet recording head for a long period of time.

### Liquid Ejection Head in Which Inorganic Substrate Is Used as Base Material Step of Forming Bonding Substrate

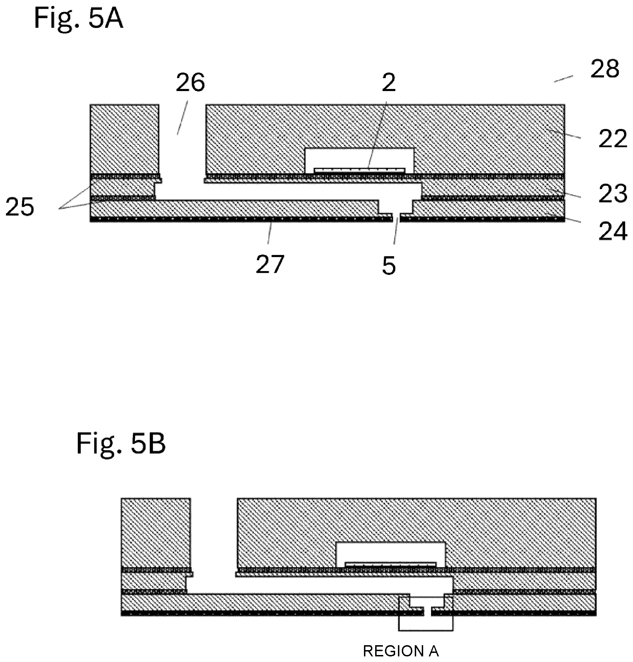

In a liquid ejection head, such as an inkjet recording head, an inorganic substrate may be used as a base material. An example of an inkjet recording head in which an inorganic substrate is used is shown in FIG. 5A.

A liquid ejection head 28 includes a flow path substrate 22, an actuator substrate 23, and a nozzle substrate 24, and the individual substrates are bonded to each other via an adhesive 25. The actuator substrate 23 has a piezoelectric element 2 disposed on a surface thereof. As the piezoelectric element 2, for example, a lead zirconate titanate (PZT) film formed by a sol-gel method or a sputtering method can be applied. Such a piezoelectric element 2 is made of a sintered body of a metal oxide crystal.

The flow path substrate 22 containing silicon is disposed to cover the piezoelectric element 2 and is bonded to a front surface of the actuator substrate 23 via the adhesive 25. In addition, the nozzle substrate 24 is bonded to a rear surface of the actuator substrate 23 via the adhesive 25. An ink tank (not shown) is disposed on the flow path substrate 22, and a liquid flow path portion 26 is formed so as to penetrate through the flow path substrate 22. The liquid flow path portion 26 communicates with the inside of the actuator substrate and is connected to a liquid ejection port 5 in the nozzle substrate.

When a drive voltage is applied to the piezoelectric element 2 from a drive IC (not shown), the piezoelectric element 2 deforms by an inverse piezoelectric effect. When a drive voltage of a Pull-Push-Pull waveform is applied, the insides of the cavities are expanded and contracted to cause a volume change, and when the liquid in the liquid flow path is pressurized, a meniscus is spread on the surface of the liquid ejection port 5. After that, the liquid pressurized by contraction is ejected from the liquid ejection port 5 as liquid droplets.

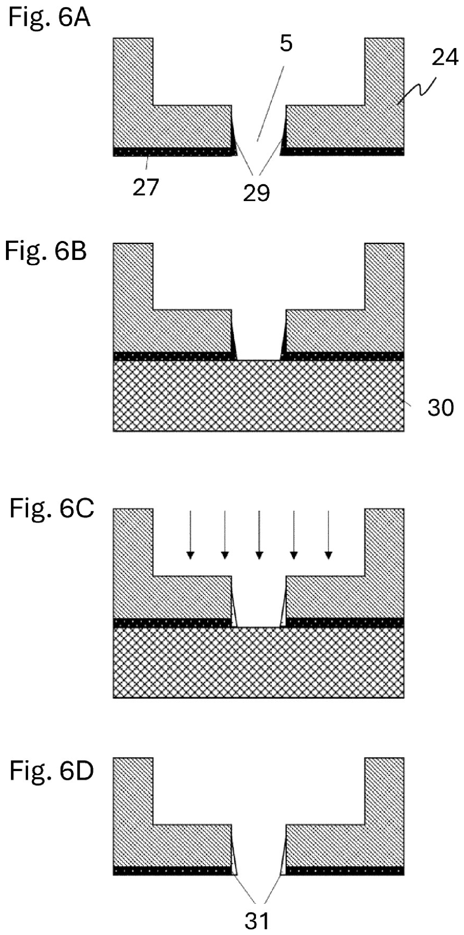

The inkjet recording head has a liquid-repellent antifouling film 27 on a surface where the liquid ejection port 5 is provided. As the liquid-repellent antifouling film 27, the above-described silicone-containing film can be used. However, when the inside of the nozzle of the liquid ejection port 5 is water-repellent, the meniscus is spread behind the nozzle, and the ejection volume or the ejection direction may become unstable. Therefore, the liquid-repellent antifouling film 27 is preferably formed by the following means. In FIGS. 5A and 5B, a peripheral region of the liquid ejection port 5 is defined as a region A. In FIGS. 6A to 6D, the region A will be described in an enlarged manner.

### Method for Forming Liquid-Repellent Antifouling Film

A method for forming a liquid-repellent antifouling film in a liquid ejection head will be described.

The formation of the liquid-repellent antifouling film is composed of performing, on a substrate bonded via the adhesive,
(1) a liquid-repellent antifouling film formation step of forming a liquid-repellent antifouling film on the surface of a nozzle substrate and inside a nozzle,
(2) a surface protection step of forming a protective member on the liquid-repellent antifouling film on the surface of the nozzle substrate,
(3) a plasma treatment step of making the liquid-repellent antifouling film inside the nozzle hydrophilic by a plasma treatment, and
(4) a protective member peeling step of peeling the protective member.

Each step will be described below in detail.

### (1) Liquid-Repellent Antifouling Film Formation Step

A liquid-repellent antifouling film made of a cured product of a resin composition containing a both-terminal epoxy silicone resin and a photocationic polymerization initiator is formed on a nozzle substrate where a plurality of ejection ports have been formed. FIG. 6A is an enlarged view of a portion where the ejection port 5 has been formed in the region A. It is preferable to use the nozzle substrate 24 in a state where the flow path substrate 22 and the actuator substrate 23 have been bonded together. Before the formation of the liquid-repellent antifouling film, the surface of the nozzle substrate may be cleaned. It is possible to use, for example, a plasma treatment, ion beam cleaning, UV ozone cleaning, or the like.

The liquid-repellent antifouling film 27 may be formed by the above-described application and curing of the coating film.

As shown in FIG. 6A, the liquid-repellent antifouling film 27 is formed on the surface where the ejection port 5 is provided. Here, since the ejection port 5 has been formed in the nozzle substrate 24, a liquid-repellent antifouling film 29 also has been formed inside the ejection port 5. Therefore, the liquid-repellent antifouling film 27 on the surface of the nozzle substrate remains, and the liquid-repellent antifouling film 29 on the side wall portion of the ejection port inside the nozzle is made hydrophilic.

### (2) Surface Protection Step

Next, as shown in FIG. 6B, a protective member 30 is formed at a place where the liquid-repellent antifouling film 27 needs to be left.

The protective member 30 is not particularly limited, and a resin material, a tape, or the like can be selected as appropriate. When the protective member around the ejection port floats, the liquid-repellent antifouling film on the surface is made hydrophilic by the subsequent plasma treatment. In this case, in the ejection port, ejection does not property occur due to a unstable meniscus. Therefore, it is also possible to attach a protective tape under reduced pressure to prevent the floating of the protective tape.

### (3) Plasma Treatment Step

Next, as shown in FIG. 6C, a plasma treatment is performed from the flow path substrate side, whereby making the liquid-repellent antifouling film 29 on the side wall portion of the ejection port hydrophilic and forming a hydrophilic liquid-repellent antifouling film 31.

As an example of a method for the plasma treatment, a nozzle substrate is set in a vacuum pressure chamber, and oxygen plasma is generated. The plasma reaches the ejection port from the flow path-formed substrate via the actuator substrate 23 as shown in FIG. 6C. For the plasma, a device of microwaves or remote plasma can be used depending on the purpose. Since the plasma moves through a bent flow path, conditions in which a substrate bias is eliminated and reliance on ion assist is avoided are preferable. Therefore, it becomes possible to move radicals isotropically mainly using a reaction of the radicals. Regarding the treatment temperature, the lower limit temperature relates to the treatment speed and thus needs to be determined in consideration of a throughput, and the upper limit temperature needs to be determined from the viewpoint of the heat resistance of the protective tape.

### (4) Protective Member Peeling Step

Finally, as shown in FIG. 6D, the liquid ejection head is prepared by peeling the protective member 30 from the nozzle substrate. In the liquid ejection head thus obtained, since the inside of the nozzle is hydrophilic, the ejection volume or the ejection direction is stabilized.

### Examples

Hereinafter, the present disclosure will be further described in detail with reference to examples, but the present disclosure is not limited to the following examples.

### Example 1

### Preparation of Liquid-Repellent Antifouling Film on Base Material

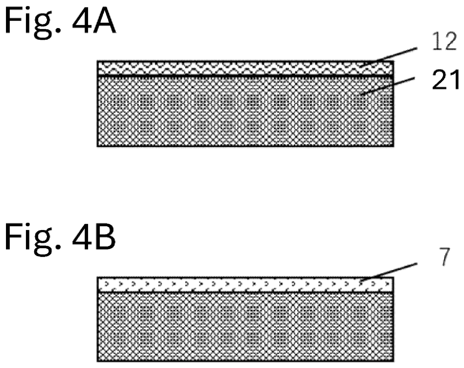

A liquid-repellent antifouling film was formed according to a procedure shown in FIGS. 4A and 4B. A photosensitive resin composition in which a silicone compound, an epoxy resin, an initiator, and a solvent have been mixed together according to a formulation of Example 1 shown in Table 3 was applied onto a silicon substrate 21 to form a coating film 12, and the coating film was heat-treated at 70°C for three minutes. Subsequently, the coating film 12 was exposed at 5000 Jm⁻² using an i-line stepper ("FPA-3000i5+" manufactured by Canon Inc.) and heat-treated at 90°C for five minutes. After washed using PGMEA, the coating film was further heat-treated at 200°C for one hour, thereby forming a liquid-repellent antifouling film 7.

PGMEA was used as the solvent.

### Preparation of Inkjet Recording Head

In addition, an inkjet recording head was prepared by steps shown in FIGS. 2A to 2H separately from the liquid-repellent antifouling film.

First, as shown in FIG. 2A, a substrate 1 having energy generation elements 2 provided on a surface was prepared, and an ink feeding port 3 penetrating the substrate 1 as shown in FIG. 2B was formed by etching using TMAH.

Next, as shown in FIG. 2C, a cationic polymerizable resin composition shown in Table 2 was transferred onto the substrate 1 including the energy generation elements 2 by a laminate method to form a first photosensitive resin layer 10. Furthermore, as shown in FIG. 2D, pattern exposure was performed through a mask made of quartz (not shown), and a heat treatment was performed at 90°C for five minutes, thereby forming sidewalls 8. As an exposure device, an i-line stepper ("FPA-3000i5+" manufactured by Canon Inc.) was used, and the exposure amount was set to 10000 Jm⁻².

A second photosensitive resin layer 11 was formed on the substrate 1 on which the side walls 8 had been formed as described above as shown in FIG. 2E. The second photosensitive resin layer 11 was transferred by the laminate method using a cationic polymerizable resin composition shown in Table 2.

Next, as shown in FIG. 2F, a photosensitive resin composition having a formulation of Example 1 shown in Table 4 was applied onto the second photosensitive resin layer 11 and heat-treated at 70°C for three minutes. Furthermore, pattern exposure was performed collectively on the second photosensitive resin layer 11 and the coating film 12 via a mask (not shown) having a pattern of ejection ports 5, and heat-treated at 90°C for five minutes. As an exposure device, an i-line stepper ("FPA-3000i5+" manufactured by Canon Inc.) was used, and the exposure amount was set to 5000 Jm⁻² (FIG. 2G).

Finally, non-exposed portions of the photosensitive resin layer and the coating film were dissolved and removed using PGMEA, and heat-treated at 200°C for one hour, thereby forming the ejection ports 5, the flow path 6, and the liquid-repellent antifouling film 7 (FIG. 2H).

**Table 2**

| | | |
|---|---|---|
| Epoxy resin | Trade name: EPICLON N-695, Manufactured by DIC Corporation | 100 Parts by mass |
| Photopolymerization initiator | Trade name: ADEKA ARKLS SP-172, Manufactured by ADEKA Corporation | 6 Parts by mass |
| Solvent | Trade name: OMR thinner, Tokyo Ohka Kogyo Co., Ltd. | 70 Parts by mass |

**[Table 3] Table 3**

| | | |
|---|---|---|
| Epoxy resin | Trade name: 157S70, Manufactured by Mitsubishi Chemical Corporation | 100 Parts by mass |
| Photopolymerization initiator | Trade name: CPI-410S, Manufactured by San-Apro Ltd. | 0.01 Parts by mass |
| Solvent | Trade name: PGMEA,Manufactured by Kishida Chemical Co., Ltd. | 20 Parts by mass |

### Examples 2 to 36

Liquid-repellent antifouling films on base materials and inkjet recording heads were prepared in the same manner as in Example 1 except that resin compositions having formulations of Examples 2 to 36 shown in Table 4 were used respectively in the formation of the liquid-repellent antifouling film 7.

### Comparative Examples 1 and 2

Liquid-repellent antifouling films on base materials and inkjet recording heads were prepared in the same manner as in Example 1 except that resin compositions having formulations of Comparative Examples 1 and 2 shown in Table 4 were used respectively in the formation of the liquid-repellent antifouling film 7.

The silicone compound, epoxy resin, and initiator used regarding the composition of each of the Examples and Comparative Examples in Table 4 are as follows.

Examples where an alkylsiloxane resin having a structure indicated by a formula (1) was used are Examples 1 to 36 and Comparative Example 2.

The photopolymerization initiators are cationic polymerizable in Examples 1 to 36 and Comparative Examples 1 and 2.

### Evaluation of Liquid-Repellent Antifouling Film

The following evaluations were performed on the liquid-repellent antifouling films prepared in Examples 1 to 36 and Comparative Examples 1 and 2.

### Liquid Repellency

The liquid-repellent antifouling film was immersed in ink containing a pigment and a solvent and held at 70°C for one week. After that, the dynamic receding contact angle θr of the liquid-repellent antifouling film with respect to pure water was measured using a micro contact angle meter (DropMeasure (trade name), manufactured by MicroJet Inc) to evaluate liquid repellency.

### Epoxy Ring-Opening Rate

In order to evaluate the ring-opening rate of the epoxy group in the water-repellent antifouling film, the decrease ratio of the peak area of the epoxy group after exposure and heat curing was calculated from the peak area of the epoxy group in an uncured state using FT-IR. The epoxy ring-opening rate was calculated by the following formula. 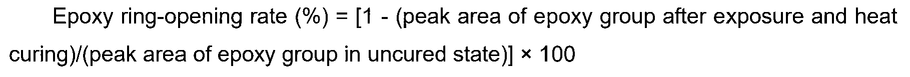 Epoxy ring-opening rate (%) = [1 - (peak area of epoxy group after exposure and heat curing)/(peak area of epoxy group in uncured state)] × 100

### FT-IR measurement conditions

Device name: Cary 620 FT-IR manufactured by Agilent Technologies, Inc.
Measurement resolution: 8 cm⁻¹
Number of times of scanning: 60 times
Measurement wavenumber range: 4000 to 900 cm⁻¹

### Evaluation of Inkjet Recording Head

The inkjet recording heads prepared in Examples 1 to 36 and Comparative Examples 1 and 2 were evaluated as follows.

A continuous printing test was performed using a printer MB5330 manufactured by Canon Inc. under an environment of 30°C and 80%RH, and the presence or absence of dot gain was visually confirmed. In the continuous printing test, 100 prints of A4-sized solid fill were continuously printed. Printing quality was determined as NG in a case where print gain was generated even at one place in the A4-sized plate.

**Table 4**

| Example No. | Epoxy silicone | | | Epoxy resin | | | Initiator | | | Solve nt | Liquid repelle ncy | Epoxy ring-opening rate |
|---|---|---|---|---|---|---|---|---|---|---|---|---|
| | Kind | Product name | Parts | Product name | Epoxy equivalent | Parts | Kind | Product name | Parts | Parts | | % |
| 1 | Both-terminal alicyclic type | X-22-169B | 1.0 | EHPE 3150 | 170-190 | 100 | Borate | CPI-410B | 3.0 | 920 | 93 | 78 |
| 2 | Both-terminal alicyclic type | X-22-169B | 0.1 | EHPE 3150 | 170-190 | 100 | Borate | CPI-410B | 3.0 | 920 | 83 | 50 |
| 3 | Both-terminal alicyclic type | X-22-169B | 0.5 | EHPE 3150 | 170-190 | 100 | Borate | CPI-410B | 3.0 | 920 | 90 | 65 |
| 4 | Both-terminal alicyclic type | X-22-169B | 1.5 | EHPE 3150 | 170-190 | 100 | Borate | CPI-410B | 3.0 | 920 | 92 | 79 |
| 5 | Both-terminal alicyclic type | X-22-169B | 1.0 | EHPE 3150 | 170-190 | 100 | Borate | CPI-410B | 0.1 | 920 | 82 | 40 |
| 6 | Both-terminal alicyclic type | X-22-169B | 1.0 | EHPE 3150 | 170-190 | 100 | Borate | CPI-410B | 1.5 | 920 | 85 | 49 |
| 7 | Both-terminal alicyclic type | X-22-169B | 1.0 | EHPE 3150 | 170-190 | 100 | Borate | CPI-410B | 2.0 | 920 | 90 | 67 |
| 8 | Both-terminal alicyclic type | X-22-169B | 1.0 | EHPE 3150 | 170-190 | 100 | Borate | CPI-410B | 3.5 | 920 | 93 | 82 |
| 9 | Both-terminal alicyclic type | X-22-169B | 1.0 | EHPE 3150 | 170-190 | 100 | Borate | CPI-410B | 5.0 | 920 | 94 | 85 |
| 10 | Both-terminal alicyclic type | X-22-169B | 1.0 | EHPE 3150 | 170-190 | 100 | Borate | CPI-310B | 3.0 | 920 | 86 | 56 |
| 11 | Both-terminal alicyclic type | X-22-169B | 1.0 | EHPE 3150 | 170-190 | 100 | Borate | ES-1B | 3.0 | 920 | 83 | 53 |
| 12 | Both-terminal alicyclic type | X-22-169B | 1.0 | EHPE 3150 | 170-190 | 100 | Gallate | VC-1FG | 3.0 | 920 | 88 | 60 |
| 13 | Both-terminal alicyclic type | X-22-169B | 1.0 | EHPE 3150 | 170-190 | 100 | Gallate | CPI-310FG | 3.0 | 920 | 84 | 56 |
| 14 | Both-terminal alicyclic type | X-22-169B | 1.0 | EHPE 3150 | 170-190 | 100 | Antimony | SP-172 | 3.0 | 920 | 84 | 48 |
| 15 | Both-terminal alicyclic type | X-22-169B | 1.0 | EHPE 3150 | 170-190 | 100 | Antimony | CPI-101A | 3.0 | 920 | 83 | 48 |
| 16 | Both-terminal alicyclic type | X-22-169B | 1.0 | EHPE 3150 | 170-190 | 100 | Phosphorus | CPI-410S | 1.0 | 920 | 81 | 51 |
| 17 | Both-terminal | X-22-163B | 1.0 | EHPE 3150 | 170-190 | 100 | Borate | CPI-410B | 1.0 | 920 | 81 | 53 |
| 18 | Both-terminal alicyclic type | X-22-169B | 1.0 | 157S70 | 200-220 | 100 | Borate | CPI-410B | 3.0 | 920 | 85 | 50 |
| 19 | Both-terminal alicyclic type | X-22-169B | 1.0 | N-695 | 209-219 | 100 | Borate | CPI-410B | 3.0 | 920 | 83 | 45 |
| 20 | Both-terminal alicyclic type | X-22-169B | 1.0 | 2021P | 130 | 100 | Borate | CPI-410B | 3.0 | 920 | 80 | 50 |
| 21 | Both-terminal alicyclic type | X-22-169B | 1.0 | 2021P | 130 | 100 | Gallate | CPI-310FG | 3.0 | 920 | 82 | 51 |
| 22 | Both-terminal alicyclic type | X-22-169B | 1.0 | 2021P | 130 | 100 | Antimony | SP-172 | 3.0 | 920 | 83 | 50 |
| 23 | Both-terminal alicyclic type | X-22-169B | 1.0 | 157S70 | 200-220 | 100 | Borate | CPI-410B | 3.0 | 920 | 85 | 53 |
| 24 | Both-terminal alicyclic type | X-22-169B | 1.0 | 157S70 | 200-220 | 100 | Gallate | CPI-310FG | 3.0 | 920 | 86 | 51 |
| 25 | Both-terminal alicyclic type | X-22-169B | 1.0 | 157S70 | 200-220 | 100 | Antimony | SP-172 | 3.0 | 920 | 85 | 50 |
| 26 | Both-terminal alicyclic type | X-22-169B | 1.0 | N695 | 209-219 | 100 | Gallate | CPI-310FG | 3.0 | 920 | 81 | 48 |
| 27 | Both-terminal alicyclic type | X-22-169B | 1.0 | N695 | 209-219 | 100 | Antimony | SP-172 | 3.0 | 920 | 80 | 50 |
| 28 | Both-terminal alicyclic type | X-22-169B | 1.0 | N865 | 209-219 | 100 | Borate | CPI-410B | 3.0 | 920 | 82 | 49 |
| 29 | Both-terminal alicyclic type | X-22-169B | 1.0 | N865 | 209-219 | 100 | Gallate | CPI-310FG | 3.0 | 920 | 80 | 47 |
| 30 | Both-terminal alicyclic type | X-22-169B | 1.0 | N865 | 209-219 | 100 | Antimony | SP-172 | 3.0 | 920 | 80 | 45 |
| 31 | Both-terminal alicyclic type | X-22-169B | 1.0 | HP 7200 | 254-264 | 100 | Borate | CPI-410B | 3.0 | 920 | 81 | 44 |
| 32 | Both-terminal alicyclic type | X-22-169B | 1.0 | HP 7200 | 254-264 | 100 | Gallate | CPI-310FG | 3.0 | 920 | 82 | 48 |
| 33 | Both-terminal alicyclic type | X-22-169B | 1.0 | HP 7200 | 254-264 | 100 | Antimony | SP-172 | 3.0 | 920 | 82 | 45 |
| 34 | Side chain both-terminal | X-22-9002 | 1.0 | EHPE 3150 | 170-190 | 100 | Borate | CPI-410B | 3.0 | 920 | 90 | 77 |
| 35 | Side chain both-terminal | X-22-9002 | 1.0 | EHPE 3150 | 170-190 | 100 | Gallate | CPI-310FG | 3.0 | 920 | 85 | 68 |
| 36 | Side chain both-terminal | X-22-9002 | 1.0 | EHPE 3150 | 170-190 | 100 | Antimony | SP-172 | 3.0 | 920 | 83 | 82 |
| | | | | | | | | | | | | |
| Comparative 1 | Single-terminal | X-22-173 | 1.0 | EHPE3150 | 170-190 | 100 | Borate | CPI-410B | 3.0 | 920 | 58 | 33 |
| Comparative 2 | Both-terminal alicyclic type | X-22-169B | 1.0 | EHPE 3150 | 170-190 | 100 | Benzoyl oxide | BPO | 3.0 | 920 | 43 | 10 |

In the table, "parts" indicates "parts by mass". Silicone compounds beginning with a product name of X-22 are manufactured by Shin-Etsu Chemical Co., Ltd. DOWSIL series is manufactured by Dow Toray Co., Ltd. The units of the epoxy equivalents are g/eq.

Epoxy silicones are as follows.

Both-terminal alicyclic types are silicone compounds having alicyclic epoxy-containing groups at both terminals of a silicone main chain, and the silicone compounds have no epoxy-containing groups in side chains.

Both terminals are silicone compounds having epoxy-containing groups (that are not alicyclic epoxy) at both terminals of silicone main chains, and the silicone compounds have no epoxy-containing groups in side chains. Side-chain both-terminals are silicone compounds having epoxy-containing groups at both terminals of the silicone main chain and a side chain.

One terminal is a silicone compound having an epoxy-containing group at one terminal of the silicone main chain.

EHPE 3150 is manufactured by Daicel Corporation. 157S70 is manufactured by Mitsubishi Chemical Corporation. N-695 is EPICRON N-695; N865 is EPICRON N-695; HP7200 is EPICRON HP-7200, and all of them are manufactured by DIC Corporation. 2021P is CELLOXIDE 2021P manufactured by Daicel Corporation.

Regarding the initiators, photopolymerization initiators are as described above in the specification. As BPO, benzoyl peroxide: manufactured by Tokyo Chemical Industry Co., Ltd. was used.

As shown in Table 4, in Examples 1 to 36, high liquid repellency was exhibited due to strong bonds by polymerization reactions between epoxies.

This is considered to be because the siloxane main chain was sufficiently fixed in the film by the epoxy silicone resin having epoxy-containing groups at both terminals.

It was found that the epoxy resin having a small epoxy equivalent has excellent reactivity with the silicone compound and is thus superior in terms of liquid repellency.

Furthermore, it was found that since EHPE3150, which is an alicyclic epoxy resin, has excellent compatibility with a silicone compound, higher liquid repellency is obtained, and EHPE3150 is suitable as an epoxy resin.

In addition, when an initiator having a borate-based anion was used, higher liquid repellency was obtained. This is considered to be because cationic polymerization performance or crosslinking reaction performance is excellent even in borate-based, phosphorus-based, antimony-based, and gallate-based anions having high acid strength in anion portions.

On the other hand, in Comparative Examples 1 and 2, the liquid repellency was insufficient. It is considered that the silicone compounds are not sufficiently fixed in the films. In the silicone compounds containing one epoxy group, the degrees of freedom in the siloxane main chain is too high, and it is thus considered that the structures are likely to deteriorate and the liquid repellency is poor. In addition, when the resin composition contains no photocationic polymerization initiators, polymerization reactions do not proceed, and it is thus considered that the fixation of the silicone compound becomes insufficient.

In the evaluations where the inkjet recording heads were used, there was no gain even in continuous printing and high printing qualities were exhibited in Examples 1 to 36. On the other hand, in Comparative Examples 1 and 2, gain was observed after continuous printing.

Various embodiments have been described in detail above but it will be understood that the present disclosure is not limited to these embodiments and encompasses all modifications, variants, alternatives and equivalents falling within the scope of the appended claims.

## Claims

1. A liquid ejection head comprising:
an ejection port for ejecting a liquid; and
an energy generation element for generating energy for ejecting the liquid from the ejection port,
wherein a silicone-containing film is formed on a surface of the liquid ejection head where the ejection port is provided, and
the silicone-containing film contains a cured product of a resin composition containing a both-terminal epoxy silicone resin and a photocationic polymerization initiator.

2. The liquid ejection head according to claim 1, wherein the both-terminal epoxy silicone resin is an alkylsiloxane resin having a structure indicated by the following formula (1); 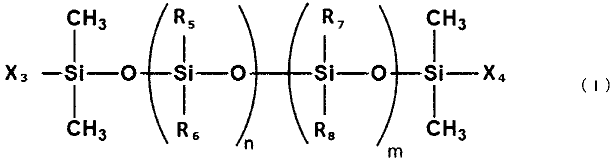
in formula (1), R₅ and R₆ are each independently an alkyl group having 1 to 12 carbon atoms or an aryl group having 6 to 12 carbon atoms,
X₃ and X₄ are each independently an epoxy-containing group,
R₈ is an epoxy-containing group, an alkyl group having 1 to 12 carbon atoms, or an aryl group having 6 to 12 carbon atoms,
R₇ is an alkyl group having 1 to 12 carbon atoms or an aryl group having 6 to 12 carbon atoms, and
arrangements of the structure in a parenthesis with m and the structure in a parenthesis with n may be random arrangements or block arrangements, m is an integer of 0 to 3, and n + m is an integer of 1 to 60.

3. The liquid ejection head according to claim 2, wherein the R₅ and the R₆ are each independently an alkyl group having 1 to 4 carbon atoms,
the R₈ is an epoxy-containing group or an alkyl group having 1 to 4 carbon atoms,
the R₇ is an alkyl group having 1 to 4 carbon atoms, and
m is 0 or 1.

4. The liquid ejection head according to claim 2 or 3, wherein the epoxy-containing group is a group having a glycidyl ether group or a group having an epoxycyclohexyl group.

5. The liquid ejection head according to any one of claims 2 to 4, wherein the epoxy-containing group is a 2-(3,4-epoxycyclohexyl)ethyl group.

6. The liquid ejection head according to any one of claims 1 to 5, wherein the cured product of the resin composition has an epoxy ring-opening rate of 40% or more.

7. The liquid ejection head according to any one of claims 1 to 6, wherein the resin composition contains an epoxy resin different from the both-terminal epoxy silicone resin.

8. The liquid ejection head according to claim 7, wherein the surface where the ejection port is provided contains a cured product of an epoxy resin, and
the epoxy resin forming the surface where the ejection port is provided contains an epoxy resin having the same structure as that of the epoxy resin in the resin composition.

9. The liquid ejection head according to claim 7 or 8, wherein the epoxy resin in the resin composition is at least one selected from the group consisting of an epoxy resin having an alicyclic skeleton, an epoxy resin having a bisphenol skeleton, an epoxy resin having a phenol novolac skeleton, an epoxy resin having a cresol novolac skeleton, an epoxy resin having a norbornene skeleton, an epoxy resin having a terpene skeleton, an epoxy resin having a dicyclopentadiene skeleton, and an epoxy resin having an oxycyclohexane skeleton.

10. The liquid ejection head according to any one of claims 7 to 9, wherein the epoxy resin in the resin composition has an epoxy equivalent of 300 g/eq. or less.

11. The liquid ejection head according to any one of claims 7 to 10, wherein the epoxy resin in the resin composition has an alicyclic epoxy resin.

12. The liquid ejection head according to any one of claims 7 to 11, wherein a content of the both-terminal epoxy silicone resin in the resin composition is 0.2 to 5.0 parts by mass relative to 100 parts by mass of the epoxy resin.

13. The liquid ejection head according to any one of claims 1 to 12, wherein the surface where the ejection port is provided is a cured product of a negative type epoxy resin composition containing a polyfunctional epoxy resin.

14. The liquid ejection head according to any one of claims 1 to 13, wherein the photocationic polymerization initiator contains an initiator having a borate-based anion.

15. A method for producing a liquid ejection head having an ejection port for ejecting a liquid and an energy generation element for generating energy for ejecting the liquid from the ejection port,
wherein a silicone-containing film is formed on a surface of the liquid ejection head where the ejection port is provided,
the surface where the ejection port is provided is a surface of an ejection port-forming member that forms a flow path of the liquid that communicates with the ejection port,
the production method comprises:
a step of forming a photosensitive resin layer that forms the ejection port-forming member;
a step of forming a layer of a resin composition that forms the silicone-containing film on the photosensitive resin layer; and
a step of exposing and developing the photosensitive resin layer and the layer of the resin composition to form the ejection port-forming member and the silicone-containing film, and
the resin composition contains a both-terminal epoxy silicone resin and a photocationic polymerization initiator.
